# EUROPEAN PATENT APPLICATION

(11) **EP 4 362 064 A1**
(43) Date of publication of application: **01.05.2024**
(21) Application number: 22832794.6
(22) Date of filing: 13.06.2022
(51) Int. Cl.: H01L 21/02, B32B 7/12, B32B 9/00, B32B 37/12, B32B 37/14, C09J 11/06, C09J 183/04, C09J 201/00

(54) **METHOD FOR PRODUCING MULTILAYER BODY, AND MULTILAYER BODY**

(30) Priority: 30.06.2021 JP 2021108617; 13.10.2021 JP 2021168166
(71) Applicant: DAIKIN INDUSTRIES, LTD., Osaka-Shi, Osaka 530-0001 (JP)
(72) Inventor: NAMIKAWA, Takashi, Osaka-shi, Osaka 530-8323 (JP); NAKAGAWA, Chihiro, Osaka-shi, Osaka 530-8323 (JP); MATSUNAGA, Takayuki, Osaka-shi, Osaka 530-8323 (JP)
(74) Representative: Hoffmann Eitle
(86) International application number: PCT/JP2022/023647
(87) International publication number: WO 2023/276638

(57) **Abstract**

The present invention provides a method for producing a laminate including two silicon substrates, comprising: (a) providing a first silicon substrate having a first bonding part and a second silicon substrate having a second bonding part, wherein the first bonding part and the second bonding part are portions containing a silicon oxide; and (b) using an organic material reactive with a hydrosilyl group and/or a silanol group to thereby bond the first bonding part and the second bonding part by a reaction product derived from the organic material.

## Description

### Technical Field

The present disclosure relates to a method for producing a laminate including two silicon substrates (hereinafter also simply referred to as "laminate" in the present specification) and the laminate.

### Background Art

In the field of semiconductor technology, silicon direct bonding (SDB) method is conventionally known as a method for bonding two silicon substrates. In the conventional general SDB method, first, two silicon substrates are cleaned to form a thin film of ions/molecules such as OH⁻, H⁺, H₂O, H₂ and O₂ on the bonding surfaces. These silicon substrates are then brought into close contact with each other to make a temporarily bond by van der Waals forces between ions/molecules, and then subjected to a heat treatment at about 1,000°C to cause inter-atomic interdiffusion, so that the silicon substrates are strongly bonded.

However, in the conventional general SDB method, a problem may arise that gas generated between the silicon substrates resulting from the heat treatment is not completely discharged and remains to form voids. According to the disclosure in Patent Literature 1 to solve the problem, a trench and a gas outlet are formed in at least one of the two silicon substrates, such that the gas generated by heat treatment is discharged through the trench and the gas outlet without occurrence of voids.

### Citation List

### Patent Literature

Patent Literature 1: JP 2007-184546 A

### Summary of Invention

### Technical Problem

However, in the method described in Patent Literature 1, it is necessary to form a trench and a gas outlet in at least one of the silicon substrates, so that the production process of the laminate is complicated. In addition, in recent years, in the field of semiconductor technology, three-dimensional integration technology including bonding (laminating) two or more silicon substrates has been researched and developed, and a novel bonding method for silicon substrates is required.

An object of the present disclosure is to provide a method for producing a laminate including two silicon substrates, which includes a novel bonding method of two silicon substrates. A further object of the present disclosure is to provide a novel laminate including two silicon substrates.

### Solution to Problem

[1] A method for producing a laminate including two silicon substrates, comprising:
   (a) providing a first silicon substrate having a first bonding part and a second silicon substrate having a second bonding part, wherein the first bonding part and the second bonding part are portions containing a silicon oxide; and
   (b) using an organic material reactive with a hydrosilyl group and/or a silanol group to thereby bond the first bonding part and the second bonding part by a reaction product derived from the organic material.
[2] The method for producing a laminate according to item [1],
   wherein the organic material has at least one selected from the group consisting of an alkenyl group, a hydroxyl group, a hydrolyzable silyl group, an isocyanate group, an epoxy group, an amino group, an acid anhydride group and a siloxane bond.
[3] The method for producing a laminate according to item [1] or [2], further comprising:
   subjecting at least one of the first bonding part and the second bonding part to a surface treatment to produce a hydrosilyl group and/or a silanol group, after the (a) and before the (b).
[4] The method for producing a laminate according to item [3],
   wherein the surface treatment includes at least one selected from the group consisting of hydrogen atom treatment, heat treatment in a hydrogen-containing atmosphere, sputtering treatment, chemical vapor deposition treatment, and terminal treatment with a chemical solution.
[5] The method for producing a laminate according to item [3] or [4],
   wherein the organic material comprises at least one selected from the group consisting of:
   (i) a substituted or unsubstituted hydrocarbon compound having alkenyl groups at two terminal parts; and
   (ii) a substituted or unsubstituted hydrocarbon compound having an alkenyl group at one terminal part and any one selected from the group consisting of a hydroxyl group, a hydrolyzable silyl group, an isocyanate group, an epoxy group, an amino group and an acid anhydride group at the other terminal part.
[6] The method for producing a laminate according to any one of items [1] to [5],
   wherein the organic material comprises at least one selected from the group consisting of:
   (iii) a substituted or unsubstituted hydrocarbon compound having any one independently selected from the group consisting of a hydroxyl group, a hydrolyzable silyl group, an isocyanate group, an epoxy group, an amino group and an acid anhydride group at two terminal parts;
   (iv) silsesquioxane and a derivative thereof;
   (v) a combination of a hydrolyzable hydrosilane or a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and
   (vi) a substituted or unsubstituted hydrocarbon compound having a hydrolyzable silyl group at one terminal part and an alkyl group at the other terminal part.
[7] The method for producing a laminate according to any one of items [1] to [6],
   wherein the organic material includes:
   (vii) a substituted or unsubstituted hydrocarbon compound having a hydrolyzable silyl group at one terminal part and a reactive functional group at the other terminal part; and
   the (b) is using the organic material and an organic binding agent having two groups bindable to the reactive functional group of the hydrocarbon compound (vii) of the organic material to thereby bond the first bonding part and the second bonding part by a reaction product derived from the organic material and the organic binding agent.
[8] The method for producing a laminate according to any one of items [1] to [7],
   wherein the (b) includes maintaining the first silicon substrate and the second silicon substrate at a temperature of 200°C or less.
[9] The method for producing a laminate according to any one of items [1] to [8],
   wherein the (b) includes maintaining the first silicon substrate and the second silicon substrate at a pressure of 10⁻⁸ Pa or more and 10⁵ Pa or less, with the organic material being interposed between the first bonding part and the second bonding part.
[10] A method for producing a laminate including two silicon substrates, comprising:
   (c) providing a first silicon substrate having a first foundation part and a first bonding part formed thereon and a second silicon substrate having a second foundation part and a second bonding part formed thereon, wherein the first foundation part and the second foundation part are portions containing silicon oxide, and the first bonding part and the second bonding part are silicon layers; and
   (d) bonding the first bonding part and the second bonding part directly, or using a hydrosilyl group present on a surface of at least one of the first bonding part and the second bonding part.
[11] A laminate comprising two silicon substrates, comprising:
   a first silicon substrate having a first bonding part;
   a second silicon substrate having a second bonding part; and
   a bonding layer bonding the first bonding part to the second bonding part,
   wherein the first bonding part and the second bonding part are portions containing silicon oxide, and the bonding layer contains an organic substance chemically bound to Si atoms of the first bonding part and Si atoms of the second bonding part.
[12] A laminate comprising two silicon substrates, comprising:
   a first silicon substrate having a first bonding part;
   a second silicon substrate having a second bonding part;
   a bonding layer bonding the first bonding part to the second bonding part,
   wherein the first bonding part and the second bonding part are portions containing silicon oxide, and the bonding layer contains an organic substance and has a thickness of 10 nm or less.
[13] The laminate according to item [11] or [12], wherein the organic substance contains a residue of an organic material reactive with a hydrosilyl group and/or a silanol group.
[14] A laminate comprising two silicon substrates, comprising:
   a first silicon substrate having a first bonding part;
   a second silicon substrate having a second bonding part;
   wherein the first bonding part and the second bonding part are silicon layers formed on a portion containing silicon oxide, and the first bonding part and the second bonding part are directly bonded, or bonded using a hydrosilyl group present on a surface of at least one of the first bonding part and the second bonding part.

### Advantageous Effects of Invention

According to the present disclosure, provided is a method for producing a laminate including two silicon substrates, which is a novel method for bonding two silicon substrates. Further, according to the present disclosure, a novel laminate including two silicon substrates is provided.

### Brief Description of Drawings

[Figure 1] Figure 1 is a schematic cross-sectional diagram showing a laminate in an embodiment of the present disclosure.
[Figure 2] Figure 2 is a schematic cross-sectional diagram showing a laminate in another embodiment of the present disclosure.

### Description of Embodiments

Embodiments of the present disclosure will be described in detail below with reference to drawings, though the present disclosure is not limited thereto.

### (Embodiment 1)

The present embodiment relates to an aspect in which each of bonding parts of two silicon substrates is a portion containing silicon oxide, and the bonding parts are bonded by an organic material.

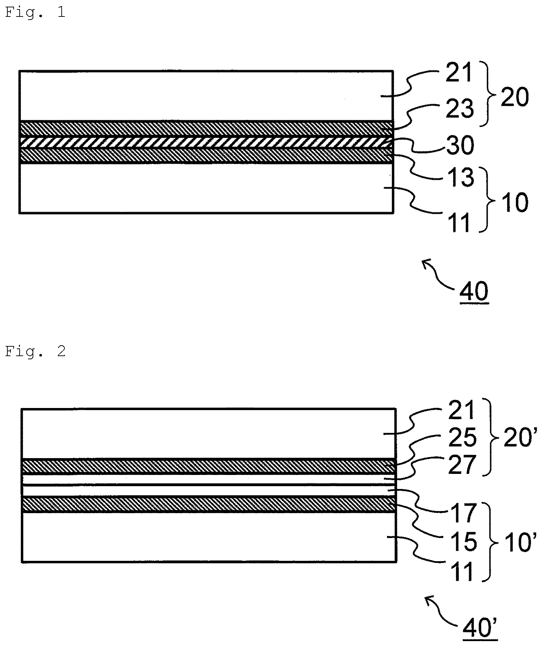

As shown in Figure 1, a laminate 40 of the present embodiment includes:
a first silicon substrate 10 having a first bonding part 13,
a second silicon substrate 20 having a second bonding part 23, and
a bonding layer 30 bonding the first bonding part 13 to the second bonding part 23.

The first silicon substrate 10 and the second silicon substrate 20 (hereinafter collectively also referred to simply as "silicon substrates") are not limited as long as they have a first bonding part 13 and a second bonding part 23 (hereinafter collectively also referred to simply as "bonding parts") to be bonded to each other.

In an aspect shown in Figure 1, the first bonding part 13 may be a film formed on the entire surface of one side of a main body part 11 of the first silicon substrate 10, and the second bonding part 23 may be a film formed on the entire surface of one side of a main body part 21 of the second silicon substrate 20, though the present embodiment is not limited thereto. For example, the bonding part may be a portion provided adjacent to a metal portion on the surface of a side of the silicon substrate, more specifically, a portion provided between two metal portions. In this case, hybrid bonding may be performed between the first silicon substrate and the second silicon substrate.

Such a laminate may be produced by the following production method. The method for producing the laminate of the present embodiment includes:
(a) providing a first silicon substrate 10 having a first bonding part 13 and a second silicon substrate 20 having a second bonding part 23; and
(b) supplying an organic material reactive with a hydrosilyl group and/or a silanol group to bond the first bonding part 13 to the second bonding part 23 by a reaction product derived from the organic material. Each of the steps will be described in detail as follows.

### · Step (a)

First, a first silicon substrate having a first bonding part and a second silicon substrate having a second bonding part are provided.

The silicon substrate may be a silicon-based substrate (or base) and may be made of silicon or may contain any other appropriate substance in addition to silicon. Examples of the substance include a dopant, impurities that may be inevitably mixed, metal (e.g., electrodes, wiring and vias), an oxide, nitride and/or carbide of silicon or the like (e.g., a dielectric layer, insulating layer and protecting layer).

The surface of the bonding part (bonding surface) may be the entire surface of a silicon substrate (typically, one of the two surfaces of silicon substrates facing each other) or a partial region thereof. The thickness of the bonding part is not limited as long as the desired or acceptable properties are achieved in a laminate to be finally produced.

In the present embodiment, the bonding part needs only to be a portion containing silicon oxide (hereinafter also referred to as "silicon oxide portion"). The silicon oxide portion may be made of silicon oxide or may include any other suitable substances in addition to silicon oxide. Examples of the other substances include a dopant and impurities that may be inevitably mixed.

In the present embodiment, the thickness of the bonding part as silicon oxide portion may be, for example, 1 nm or more and 1 µm or less, particularly 10 nm or less.

The bonding part may be provided on a silicon substrate by any appropriate method.

The surface of a silicon substrate before providing the bonding part (the main body part in the aspect shown in Figure 1) may be subjected to chemical mechanical polishing (CMP), which is not essential in the present embodiment, though. Thereby, the surface may be flattened/smoothed.

Alternatively, the surface of the silicon substrate before providing the bonding part (the main body part in the aspect shown in Figure 1) may be subjected to cleaning after CMP or without CMP, which is not essential in the present embodiment, though. Thereby, the surface may be cleaned, and, for example, undesired substances such as organic substances, particles, and metals/metal ions may be removed.

Cleaning may be performed by a method known in the field of semiconductor technology, though not limited thereto. Cleaning may include washing and drying. Washing may be performed, for example, by using any one or any combination of two or more of washing liquids such as SPM (H₂SO₄+H₂O₂+H₂O: piranha solution), APM (NH₄OH+H₂O₂+H₂O: SC-1, RCA-1), HPM (HCl+H₂O₂+H₂O: SC-2, RCA-2), DHF (HF+H₂O), and BHF (NH₄F+HF+H₂O), (these may be standard or modified compositions). Washing may optionally be performed by appropriately adding any one or any two or more of trichloroethylene, alcohol, acetone, deionized water, and ultrasonic waves. Further, spin drying, isopropanol (IPA) vapor drying, IPA direct substitution drying, etc. may be applied.

Depending on the chemical solution used and conditions for cleaning, ions/molecules such as OH⁻, H⁺, H₂O, H₂ and O₂ may be introduced on the surface of the silicon substrate before providing the bonding part (the main body part in the aspect shown in Figure 1), and as a result, hydrosilyl groups and/or silanol groups may be produced on the surface.

The bonding part as silicon oxide portion may be formed, for example, by oxidizing the entire surface or a partial region of the surface of a silicon substrate (typically, one of the two surfaces of silicon substrates facing each other) . Oxidation of silicon may be performed by heating in an atmosphere containing oxygen (so-called thermal oxidation) and/or by natural oxidation. Alternatively, for example, the bonding part of the present embodiment may be formed by depositing silicon oxide on the entire surface or a partial region of the surface of a silicon substrate (typically, one of the two surfaces of silicon substrates facing each other) . The deposition of silicon oxide may be performed by any one of sputtering, chemical vapor deposition (CVD), plasma enhanced chemical vapor deposition (PECVD), vapor deposition, or by any combination of two or more thereof. Alternatively, a combination of oxidation of silicon and deposition of silicon oxide may be performed. However, the method for forming the bonding part as silicon oxide portion is not limited thereto, and it may be formed by any suitable method.

On the surface of the bonding part as silicon oxide portion, a small amount of silanol groups (-Si-OH) are definitely present.

After the step (a) and before the step (b), at least one of the first bonding part and the second bonding part is preferably subjected to a surface treatment to produce hydrosilyl groups and/or silanol groups, which is not essential in the present embodiment, though. Thereby, hydrosilyl groups (-Si-H) and/or silanol groups (-Si-OH) can be present at a higher density on the surface of the bonding part. The surface treatment may be performed on the surface of the bonding part (bonding surface), and may be performed on the surface of the bonding part only or on a wider surface including the surface of the bonding part.

The surface treatment to produce hydrosilyl groups and/or silanol groups may be at least one selected from the group consisting of hydrogen atom treatment, heat treatment in a hydrogen-containing atmosphere, sputtering treatment, chemical vapor deposition treatment (CVD), and terminal treatment with a chemical solution. By the hydrogen atom treatment, heat treatment in a hydrogen-containing atmosphere, sputtering treatment, CVD, or terminal treatment with a chemical solution, hydrogen atoms can be introduced on the surface of the bonding part to produce hydrosilyl groups (-Si-H). By the terminal treatment with a chemical solution, hydroxyl groups can be introduced on the surface of the bonding part to produce silanol groups (-Si-OH).

The hydrogen atom treatment may be performed, for example, by supplying hydrogen gas at about 1×10⁻⁴ Pa into a vacuum chamber at an ultra-high vacuum (1×10⁻⁶ Pa or less), and dissociating hydrogen molecules into hydrogen atoms by thermal electrons or plasma, so that hydrogen atoms are adsorbed on the surface of the bonding part.

The heat treatment in a hydrogen-containing atmosphere may be performed, for example, by flowing hydrogen as a carrier gas during evacuation to replace the atmosphere in the chamber with hydrogen gas to create a vacuum state of a hydrogen atmosphere (specifically, hydrogen atmosphere at 10 Pa or less), and heating the substrate to about 100 to 400°C in the atmosphere, so that hydrogen is adsorbed on the surface of the bonding part.

The sputtering treatment may be performed, for example, by using silicon as sputtering source, and supplying hydrogen to be adsorbed on the surface of the bonding part.

The CVD treatment may be performed, for example, by using silane as CVD gas, and adjusting the gas pressure of hydrogen such that hydrogen atoms are adsorbed on the surface of the bonding part.

The terminal treatment with a chemical solution may be performed, for example, by immersing a silicon substrate in a chemical solution such as hydrofluoric acid aqueous solution (hydrofluoric acid) or a chemical solution of ammonium fluoride with at least the bonding part exposed, such that hydrogen ions and/or hydroxide ions are bound to the surface of the bonding part depending on the chemical solution used.

After the step (a) and before the step (b), at least one of the first bonding part and the second bonding part may be subjected to a surface treatment to produce fluorosilyl groups, which is not essential for the present embodiment, though.

The surface treatment to produce fluorosilyl groups may be at least one selected from the group consisting of CVD, discharge treatment, ion implantation, and terminal treatment with a chemical solution. The surface treatment to produce fluorosilyl groups may be performed separately or simultaneously with the surface treatment to produce hydrosilyl groups and/or silanol groups. In the case of a separate treatment, any one of the surface treatments may be performed first.

The CVD treatment may be performed using, for example, CF₄ and/or SF₆ as CVD gas to adsorb fluorine atoms onto the surface of the bonding part.

The discharge treatment may be performed, for example, by plasma discharging or corona discharging in an atmosphere containing CF₄ and/or SF₆ to adsorb fluorine radicals on the surface of the bonding part.

The ion implantation may be performed by implanting fluorine ions into the bonding part by any suitable method.

The terminal treatment with a chemical solution may be performed, for example, by immersing a silicon substrate in a chemical solution such as hydrofluoric acid aqueous solution (hydrofluoric acid) or a chemical solution of ammonium fluoride with at least the bonding part exposed, such that fluorine ions are bound to the surface of the bonding part depending on the chemical solution used. In particular, the terminal treatment with a hydrofluoric acid aqueous solution allows hydrosilyl groups (-Si-H), silanol groups (-Si-OH), and fluorosilyl groups (-Si-F) to be produced.

The first silicon substrate and the second silicon substrate are provided as described above. The first silicon substrate and the second silicon substrate need no trench and no gas outlet, though at least one thereof may have a trench and/or a gas outlet. The trench and/or the gas outlet may be formed at any suitable time.

### ·Step (b)

Next, an organic material reactive with hydrosilyl groups and/or silanol groups is supplied between the first bonding part and the second bonding part, so that the first bonding part and the second bonding part are bonded by a reaction product derived from the organic material.

A specific aspect of the method for supplying the organic material and the method for bonding may be appropriately selected according to the organic material to be used. Schematically, after supplying the organic material, the first silicon substrate and the second silicon substrate are maintained under specified reaction conditions (at a predetermined temperature, in particular), with the organic material interposed between the first bonding part and the second bonding part, so that the first bonding part and the second bonding part may be bonded by a reaction product.

More specifically, for example, an organic material, which may be a composition, is applied to one or both of the surfaces of at least a first bonding part of the first silicon substrate and at least a second bonding part of the second silicon substrate (for example, by painting, spraying, or printing). The organic material may be applied directly or in the form of a composition mixed with any suitable component (e.g., solvent). In the case of using a composition containing an organic material, the water content in the composition is substantially zero. With such a low water content in the composition, the occurrence of voids can be reduced. Washing and/or drying may be then performed on an as needed basis. The same washing and drying as described above may be applied, and in the case of using an organic material containing fluorine, pre-washing with a fluorine-based solvent may be performed. Next, the first silicon substrate and the second silicon substrate are aligned such that the first bonding part faces the second bonding part, and the first silicon substrate and the second silicon substrate are brought into close contact, with an organic material interposed between the first bonding part and the second bonding part. The first silicon substrate and the second silicon substrate brought into close contact are maintained under predetermined reaction conditions (at a predetermined temperature, in particular), such that the reaction proceeds during this period. Annealing may be then performed on an as needed basis.

Although the reaction conditions may vary depending on the organic material used, the predetermined temperature may be, for example, 200°C or less, particularly 120°C or less, more particularly 80°C or less, and conveniently normal temperature (typically 10°C or more and 40°C or less). According to the present embodiment, since the bonding can be performed at such a relatively low temperature, the bonding deviation caused by thermal expansion of the silicon substrate can be reduced, so that the first bonding part and the second bonding part can be bonded with high accuracy. The pressure (absolute pressure, also the same for other pressure values in the present specification) is, for example, 10⁻⁸ Pa or more, particularly 10⁻⁵ Pa or more, more particularly 10⁻¹ Pa or more, and still more particularly 10² Pa or more, and conveniently normal pressure (typically about 1.01×10⁵ Pa) . In the case where a reduced pressure is applied, the pressure may be, for example, 10⁵ Pa or less, particularly 10⁴ Pa or less, more particularly 10³ Pa or less.

The organic material may be, for example, an organic material having at least one selected from the group consisting of an alkenyl group, a hydroxyl group, a hydrolyzable silyl group, an isocyanate group, an epoxy group, an amino group, an acid anhydride group, and a siloxane bond. An alkenyl group is reactive with a hydrosilyl group (-Si-H), and a hydroxyl group, a hydrolyzable silyl group, an isocyanate group, an epoxy group, an amino group, an acid anhydride group and a siloxane bond are reactive with a silanol group (-Si-OH).

More specifically, the organic material may include at least one selected from the group consisting of:
(i) a substituted or unsubstituted hydrocarbon compound having alkenyl groups at two terminal parts;
(ii) a substituted or unsubstituted hydrocarbon compound having an alkenyl group at one terminal part and any one selected from the group consisting of a hydroxyl group, a hydrolyzable silyl group, an isocyanate group, an epoxy group, an amino group and an acid anhydride group at the other terminal part;
(iii) a substituted or unsubstituted hydrocarbon compound having any one independently selected from the group consisting of a hydroxyl group, a hydrolyzable silyl group, an isocyanate group, an epoxy group, an amino group and an acid anhydride group at two terminal parts;
(iv) silsesquioxane and a derivative thereof;
(v) a combination of a hydrolyzable hydrosilane or a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part;
(vi) a substituted or unsubstituted hydrocarbon compound having a hydrolyzable silyl group at one terminal part and an alkyl group at the other terminal part; and
(vii) a substituted or unsubstituted hydrocarbon compound having a hydrolyzable silyl group at one terminal part and a reactive functional group at the other terminal part. The organic material may be made of one compound or a combination of two or more compounds.

Exemplary aspects using organic materials (i) to (vii) are described in detail in the following.

### · Example using organic material (i)

In the example, as a first silicon substrate and a second silicon substrate, ones having hydrosilyl groups (-Si-H) on the surfaces of the first bonding part and the second bonding part (silicon oxide portion in the present embodiment) are used. The first silicon substrate and the second silicon substrate having hydrosilyl groups on the surfaces of the first bonding part and the second bonding part as silicon oxide portions may be obtained, for example, by the surface treatment to produce hydrosilyl groups described above.

As the organic material, a substituted or unsubstituted hydrocarbon compound having alkenyl groups at two terminal parts is used. An alkenyl group is a reactive group for a hydrosilyl group. Such a compound may have two or more terminal parts and may have an alkenyl group at any two or more terminal parts. Such a compound may be fluorine-substituted, or in other words, may be a fluoroalkyl compound or a fluoropolyether group-containing compound having an alkenyl group at two or more terminal parts.

Exemplary fluoroalkyl compounds having an alkenyl group at two, three, or four terminal parts are shown in the following. 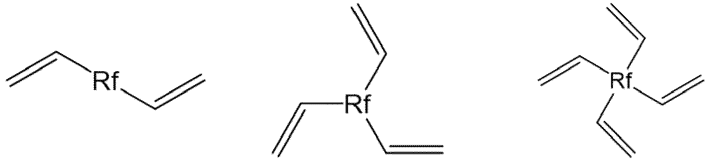 Rf represents a fluoroalkyl group (the same applies hereinafter).

The number of carbon atoms in the portion excluding the reactive groups at terminals may be, for example, 1 or more and 200 or less, particularly 100 or less, though not limited. The portions excluding the reactive groups may be in a linear, branched or cyclic form. In the case where the portion excluding the reactive groups at terminals is a fluoroalkyl group, which may be, for example, a perfluoroalkyl group without limitations on the fluorine substitution ratio.

The fluoropolyether group-containing compound having an alkenyl group at two or more terminal parts may be, for example, a compound represented by
(A) Formula (1):

   R^{D}_{γ}-X^{A}-R^{F2}-X^{A}-R^{D}_{γ} (1)

   wherein R^{F2} is -Rf²ₚ-R^{F}-O_{q}-;
   Rf² is a C₁₋₂₀ alkylene group optionally substituted with one or more fluorine atoms;
   R^{F} are each independently groups represented by the following formula at each occurrence:

      -(OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

      wherein R^{Fa} are each independently a hydrogen atom, a fluorine atom, or a chlorine atom at each occurrence,
      a, b, c, d, e and f are each independently an integer of 0 to 200, the sum of a, b, c, d, e and f is 1 or more, and the order of presence of each repeating unit bracketed and subscripted with a, b, c, d, e or f is arbitrary in the formula, provided that in the case all R^{Fa} are hydrogen atoms or chlorine atoms, at least one of a, b, c, e and f is one or more;
      p is 0 or 1;
      q is 0 or 1;
      R^{D} is CH₂=CH-;
      X^{A} are each independently a single bond or a divalent to decavalent organic group;
      γ are each independently an integer of 1 to 9;
   or
(B) Formula (2): 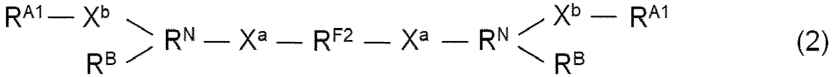 wherein R^{N} is: 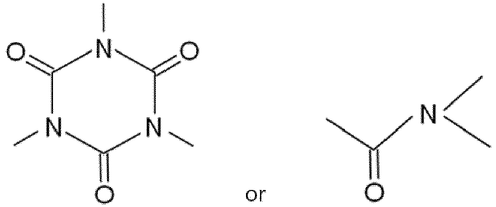
   R^{F2} is -Rf²ₚ-R^{F}-O_{q}-;
   Rf² is a C₁₋₆ alkylene group optionally substituted by one or more fluorine atoms;
   R^{F} are each independently a group represented by the following formula at each occurrence:

      -(OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

      wherein R^{Fa} are each independently a hydrogen atom, a fluorine atom, or a chlorine atom at each occurrence,
      a, b, c, d, e and f are each independently an integer of 0 to 200, the sum of a, b, c, d, e and f is 1 or more, the order of presence of each repeating unit bracketed and subscripted with a, b, c, d, e or f is arbitrary in the formula, and provided that in the case all R^{Fa} are hydrogen atoms or chlorine atoms, at least one of a, b, c, e and f is one or more;
      p is 0 or 1;
      q is 0 or 1;
      X^{a} are each independently a single bond or a divalent organic group at each occurrence;
      R^{A1} are each independently an OR^{Ac} group-containing group at each occurrence;
      R^{Ac} is a (meth)acryloyl group;
      R^{B} are each independently R^{F1}-X^{a}- or R^{A1}-X^{b}- at each occurrence;
      R^{F1} is Rf¹R^{F}-O_{q}-;
      Rf¹ is a C₁₋₁₆ alkyl group optionally substituted by one or more fluorine atoms, and
      X^{b} is a divalent organic group.

The organic material is supplied between the first bonding part and the second bonding part, so that the alkenyl groups of the organic material react with the hydrosilyl groups of the first bonding part and the second bonding part (hydrosilylation). Thereby, the reaction product derived from the organic material is chemically bound to the Si atoms of the first bonding part and the Si atoms of the second bonding part, so that the first bonding part and the second bonding part are bonded by the reaction product derived from the organic material. According to the reaction, no by-product is generated, so that the problem of formation of voids derived from by-products can be fundamentally eliminated.

Incidentally, the reaction may be performed once with the organic material sandwiched between the first bonding part and the second bonding part, or may be performed in two separate times by applying the organic material on any one of the first bonding part and the second bonding part for partial proceeding of the reaction, and then disposing another one on top of the organic material for further proceeding of the reaction.

An exemplary reaction with use of a fluoroalkyl compound having alkenyl groups at two terminal parts is shown as follows. (The same applies to a fluoropolyether group-containing compound having alkenyl groups at two terminal parts.)

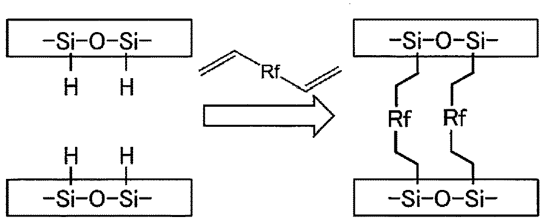

It is preferable that the reaction product derived from the organic material be chemically bound to both of the Si atoms of the first bonding part and the Si atoms of the second bonding part. However, not all of the reaction products need to be chemically bound to both of the Si atoms of the first bonding part and the Si atoms of the second bonding part. Some of the reaction products may be chemically bound only to any one of the Si atoms of the first bonding part or the Si atoms of the second bonding part, or chemically bound to two or more Si atoms in the same silicon substrate. In order to obtain higher bonding strength, it is preferable that more reaction products be chemically bound to both of the Si atoms of the first bonding part and the Si atoms of the second bonding part. From such a viewpoint, the organic material is preferably a linear compound having an alkenyl group at both terminal parts, though not limited thereto.

### · Example using organic material (ii)

In the example, as the first silicon substrate, one having silanol groups (-Si-OH) on the surface of the first bonding part (in the present embodiment, the silicon oxide portion) is used, and as the second silicon substrate, one having hydrosilyl groups (-Si-H) on the surfaces of the second bonding part (in the present embodiment, the silicon oxide portion) is used. The first silicon substrate having silanol groups on the surface of the first bonding part as silicon oxide portion requires no particular surface treatment, though the silanol groups may be obtained by the surface treatment to produce silanol groups described above on an as needed basis. The second silicon substrate having hydrosilyl groups on the surface of the second bonding part as silicon oxide portion may be obtained, for example, by the surface treatment to produce hydrosilyl groups described above.

As the organic material, a substituted or unsubstituted hydrocarbon compound having an alkenyl group at one terminal part and a hydroxyl group at the other terminal part is used. An alkenyl group is a reactive group for a hydrosilyl group, and a hydroxyl group is a reactive group for a silanol group. Such a compound may have two or more terminal parts and may have an alkenyl group at any one or more terminal parts and a hydroxyl group at any one or more terminal parts. Such a compound may be fluorine-substituted, or in other words, may be a fluoroalkyl compound or a fluoropolyether group-containing compound having an alkenyl group at one terminal part and a hydroxyl group at the other terminal part.

In addition, unless otherwise specified, the explanations described above may apply. (The same applies as described for the fluoroalkyl compound or fluoropolyether group-containing compound in detail in the (i), except for having a hydroxyl group at least at one terminal.)

The organic material is supplied between the first bonding part and the second bonding part, so that the hydroxyl groups of the organic material react with the silanol groups of the first bonding part (esterification by dehydration) and the alkenyl groups of the organic material react with the hydrosilyl groups of the second bonding part (hydrosilylation). Thereby, the reaction product derived from the organic material is chemically bound to the Si atoms of the first bonding part and the Si atoms of the second bonding part, so that the first bonding part and the second bonding part are bonded by the reaction product derived from the organic material.

More specifically, it is preferable that the organic material be supplied to the first bonding to cause a reaction between the hydroxyl groups of the organic material and the silanol groups of the first bonding part (first stage), and then the first bonding part and the second bonding part be disposed facing each other to cause a reaction between the alkenyl groups of the organic material and the hydrosilyl groups of the second bonding part (second stage). According to the procedure, water produced as a by-product in the reaction in the first stage can be removed without being trapped between the first bonding part and second bonding part, and since no by-products are generated in the second-stage reaction, formation of voids derived from the by-products can be avoided.

An exemplary reaction with use of a fluoroalkyl compound having an alkenyl group at one terminal part and a hydroxyl group at the other terminal part is shown in the following.

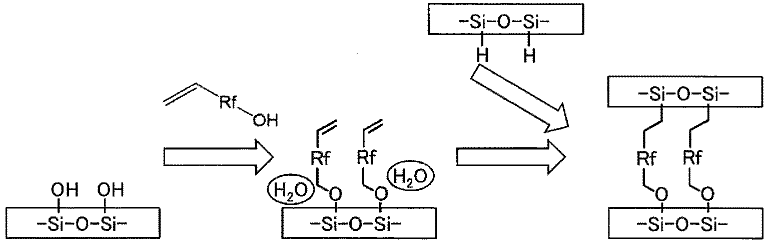

In order to obtain higher bonding strength, the organic material is preferably a linear compound having an alkenyl group and a hydroxyl group at both terminal parts, respectively, though not limited thereto.

Further, in this example, the first silicon substrate has silanol groups on the surface of the first bonding part, and the second silicon substrate has hydrosilyl groups on the surface of the second bonding part. Accordingly, in the case of using an organic material having an alkenyl group and a hydroxyl group at both terminal parts, respectively (preferably in a linear form), it can be avoided that the reaction product is chemically bound to two or more Si atoms in the same silicon substrate, so that higher bonding strength can be achieved.

Use of a substituted or unsubstituted hydrocarbon compound having an alkenyl group at one terminal part and a hydroxyl group at the other terminal part as the organic material has been described as an example however, instead of/in addition to the hydroxyl group, a substituted or unsubstituted hydrocarbon compound having a hydrolyzable silyl group, an isocyanate group, an epoxy group, an amino group or an acid anhydride group may be used. Any of a hydroxyl group, a hydrolyzable silyl group, an isocyanate group, an epoxy group, an amino group and an acid anhydride group can function as a reactive group for the silanol group. (Incidentally, the substituted or unsubstituted hydrocarbon compound having an alkenyl group at one terminal part and a hydroxyl group at the other terminal part may be the same as a substituted or unsubstituted hydrocarbon compound having hydrolyzable silyl groups at two terminal parts to be described in detail in the following (iii), except for having an alkenyl group at least at one terminal.)

### · First example using organic material (iii)

In the example, as the first silicon substrate and the second silicon substrate, ones having silanol groups (-Si-OH) on the surfaces of the first bonding part and the second bonding part (silicon oxide portion in the present embodiment) are used. The first silicon substrate and the second silicon substrate having silanol groups on the surfaces of the first bonding part and the second bonding part as silicon oxide portions require no particular surface treatment, or may be obtained by the surface treatment to produce silanol groups described above on an as needed basis.

As the organic material, a substituted or unsubstituted hydrocarbon compound having a hydrolyzable silyl group at two terminal parts is used. Such a compound may have two or more terminal parts and may have a hydrolyzable silyl group at any two or more terminal parts. Such a compound may be fluorine-substituted, or in other words, may be a fluorine-containing silane compound such as a fluoroalkyl compound or a fluoropolyether group-containing compound having a hydrolyzable silyl group at two terminal parts.

The fluorine-containing silane compound may be, for example, a compound represented by the following formula (11) :

R^{Si}_{γ}-X^{A}-R^{F2}-X^{A}-R^{Si}_{γ} (11)

wherein:
R^{F2} is -Rf²ₚ-R^{F}ᵣ-O_{q}-;
Rf² is a C₁₋₂₀ alkylene group optionally substituted by one or more fluorine atoms;
R^{F} are each independently a group represented by the following formula at each occurrence:

   -(OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

   wherein R^{Fa} are each independently a hydrogen atom, a fluorine atom, or a chlorine atom at each occurrence,
   a, b, c, d, e and f are each independently an integer of 0 to 200, the sum of a, b, c, d, e and f is 1 or more; the order of presence of each repeating unit bracketed and subscripted with a, b, c, d, e or f is arbitrary in the formula, and provided that in the case all R^{Fa} are hydrogen atoms or chlorine atoms, at least one of a, b, c, e and f is one or more;
   p is 0 or 1;
   q is 0 or 1;
   r is 0 or 1;
   provided that any one of p or r is 1;
   R^{Si} is each independently a group represented by the following formulas (S1), (S2), (S3), (S4) or (S5) at each occurrence: 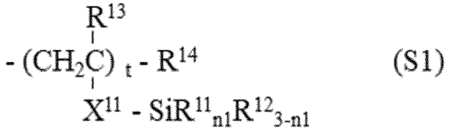 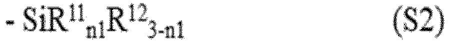 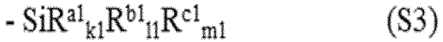 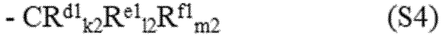 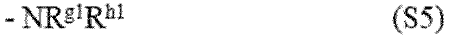 wherein:
      R¹¹ are each independently a hydroxyl group or a hydrolyzable group at each occurrence;
      R¹² are each independently a hydrogen atom or a monovalent organic group at each occurrence;
      n1 are each independently an integer of 0 to 3 for each (SiR¹¹ₙ₁R¹²₃₋ₙ₁) unit;
      X¹¹ are each independently a single bond or a divalent organic group at each occurrence;
      R¹³ are each independently a hydrogen atom or a monovalent organic group at each occurrence;
      t are each independently an integer of 2 or more at each occurrence;
      R¹⁴ are each independently a hydrogen atom, a halogen atom or -X¹¹-SiR¹¹ₙ₁R¹²₃₋ₙ₁ at each occurrence;
      R^{a1} are each independently -Z¹-SiR²¹ₚ₁R²²_{q1}R²³ᵣ₁ at each occurrence;
      Z¹ are each independently an oxygen atom or a divalent organic group at each occurrence;
      R²¹ are each independently -Z^{1'}-SiR^{21'}_{p1'}R^{22'}_{q1'}R^{23'}_{r1'} at each occurrence;
      R²² are each independently a hydroxyl group or a hydrolyzable group at each occurrence;
      R²³ are each independently a hydrogen atom or a monovalent organic group at each occurrence;
      p1 are each independently an integer of 0 to 3 at each occurrence;
      q1 are each independently an integer of 0 to 3 at each occurrence;
      r1 are each independently an integer of 0 to 3 at each occurrence;
      Z^{1'} are each independently an oxygen atom or a divalent organic group at each occurrence;
      R^{21'} are each independently -Z^{1"}-SiR^{22"}_{q1"}R^{23"}_{r1"}at each occurrence;
      R^{22'} are each independently a hydroxyl group or a hydrolyzable group at each occurrence;
      R^{23'} are each independently a hydrogen atom or a monovalent organic group at each occurrence;
      p1' are each independently an integer of 0 to 3 at each occurrence;
      q1' are each independently an integer of 0 to 3 at each occurrence;
      r1' are each independently an integer of 0 to 3 at each occurrence;
      Z^{1"} are each independently an oxygen atom or a divalent organic group at each occurrence;
      R^{22"} are each independently a hydroxyl group or a hydrolyzable group at each occurrence;
      R^{23"} are each independently a hydrogen atom or a monovalent organic group at each occurrence;
      q1" are each independently an integer of 0 to 3 at each occurrence;
      r1" are each independently an integer of 0 to 3 at each occurrence;
      R^{b1} are each independently a hydroxyl group or a hydrolyzable group at each occurrence;
      R^{c1} are each independently a hydrogen atom or a monovalent organic group at each occurrence;
      k1 are each independently an integer of 1 to 3 at each occurrence;
      l1 are each independently an integer of 0 to 3 at each occurrence;
      m1 are each independently an integer of 0 to 3 at each occurrence;
      R^{d1} are each independently -Z²-CR³¹ₚ₂R³²_{q2}R³³ᵣ₂ at each occurrence;
      Z² are each independently a single bond, an oxygen atom or a divalent organic group at each occurrence;
      R³¹ are each independently -Z^{2'}-CR^{32'}_{q2'}R^{33'}_{r2'} at each occurrence;
      R³² are each independently -Z³-SiR³⁴ₙ₂R³⁵₃₋ₙ₂ at each occurrence;
      R³³ are each independently a hydrogen atom, a hydroxyl group, or a monovalent organic group at each occurrence;
      p2 are each independently an integer of 0 to 3 at each occurrence;
      q2 are each independently an integer of 0 to 3 at each occurrence;
      r2 are each independently an integer of 0 to 3 at each occurrence;
      Z^{2'} are each independently a single bond, an oxygen atom or a divalent organic group at each occurrence;
      R^{32'} are each independently -Z³-SiR³⁴ₙ₂R³⁵₃₋ₙ₂ at each occurrence;
      R^{33'} are each independently a hydrogen atom, a hydroxyl group, or a monovalent organic group at each occurrence;
      q2' are each independently an integer of 0 to 3 at each occurrence;
      r2' are each independently an integer of 0 to 3 at each occurrence;
      Z³ are each independently a single bond, an oxygen atom or a divalent organic group at each occurrence;
      R³⁴ are each independently a hydroxyl group or a hydrolyzable group at each occurrence;
      R³⁵ are each independently a hydrogen atom or a monovalent organic group at each occurrence;
      n2 are each independently an integer of 0 to 3 at each occurrence;
      R^{e1} are each independently -Z³-SiR³⁴ₙ₂R³⁵₃₋ₙ₂ at each occurrence;
      R^{f1} are each independently a hydrogen atom, a hydroxyl group, or a monovalent organic group at each occurrence;
      k2 are each independently an integer of 0 to 3 at each occurrence;
      l2 are each independently an integer of 0 to 3 at each occurrence;
      m2 are each independently an integer of 0 to 3 at each occurrence;
      R^{g1} and R^{h1} are each independently -Z⁴-SiR¹¹ₙ₁R¹²₃₋ₙ₁, -Z⁴-SiR^{a1}ₖ₁R^{b1}ₗ₁R^{e1}ₘ₁, or -Z⁴-CR^{d1}ₖ₂R^{e1}ₗ₂R^{f1}ₘ₂ at each occurrence;
      Z⁴ are each independently a single bond, an oxygen atom or a divalent organic group at each occurrence;
      provided that, in formulas (S1), (S2), (S3), (S4) and (S5), at least one Si atom binding to a hydroxyl group or hydrolyzable group is present;
      X^{A} are each independently a single bond or a divalent to decavalent organic group; and
      γ are each independently an integer of 1 to 9.

The hydrolyzable group means a group that can be subjected to a hydrolysis reaction, preferably -OR^{j}, -OCOR^{j}, -O-N=CR^{j}₂, -NR^{j}₂, -NHR^{j} or a halogen. R^{j} is a substituted or unsubstituted C₁₋₄ alkyl group, preferably an unsubstituted C₁₋₄ alkyl group. The C₁₋₄ alkyl group is preferably an ethyl group or a methyl group, more preferably a methyl group.

The simplest hydrolyzable silyl group may be an alkoxysilyl group. The number of alkoxy group in the alkoxysilyl group is 1 or more and 3 or less, and may be, for example, 3. The number of carbon atoms in the alkoxy group may be, for example, 1 or more and 4 or less, particularly 2 or less, and preferably 1.

Unless otherwise specified, the above explanation may be applied.

The organic material is supplied between the first bonding part and the second bonding part, so that the hydrolyzable silyl groups of the organic material react with the silanol groups of the first bonding part and the second bonding part (for example, in the case where the hydrolyzable group is an alkoxy group, a siloxane bond is formed by dealcoholization). Thereby, the reaction product derived from the organic material is chemically bound to Si atoms of the first bonding part and Si atoms of the second bonding part, so that the first bonding part and the second bonding part are bonded by the reaction product derived from the organic material. As the by-product in such a reaction, for example, an alcohol is produced. The alcohol has only a small number of carbon atoms as described above, and can be removed to the outside effectively through openings of the reaction product between the first bonding part and the second bonding part, so that the formation of voids derived from by-products can be reduced.

Incidentally, the reaction may be performed once with the organic material sandwiched between the first bonding part and the second bonding part, or may be performed in two separate times by applying the organic material on any one of the first bonding part and the second bonding part for partial proceeding of the reaction, and then disposing another one on top of the organic material for further proceeding of the reaction.

An exemplary reaction with use of an alkyl compound having a trimethoxysilyl group at two terminal parts is shown as follows. (In the following, an exemplary reaction performed in two separate times as described above is also shown.)

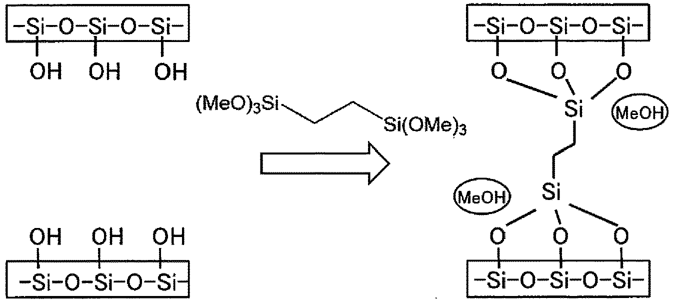

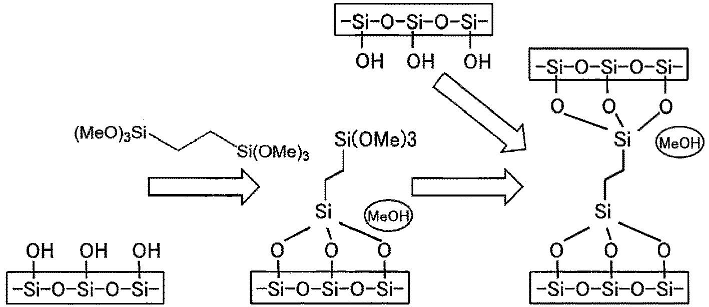

In order to obtain higher bonding strength, the organic material is preferably a linear compound having a hydrolyzable silyl group at both terminal parts, though not limited thereto.

### · Second example using organic material (iii)

In the example, differences from the first example using the organic material (iii) described above will be mainly explained, and unless otherwise specified, the explanations described in the first example may be applied.

As the organic material, a substituted or unsubstituted hydrocarbon compound having an isocyanate group at two terminal parts is used. The compound may have two or more terminal parts, and may have an isocyanate group at any two or more terminal parts.

The organic material is supplied between the first bonding part and the second bonding part, so that the isocyanate groups of the organic material react with the silanol groups of the first bonding part and the second bonding part (formation of urethane bonding). Thereby, the reaction product derived from the organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

An exemplary reaction with use of an alkyl compound having an isocyanate group at two terminal parts is shown in the following.

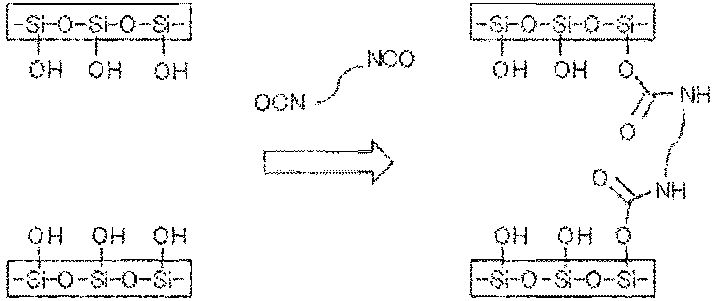

### · Third example using organic material (iii)

In the example, differences from the first example using the organic material (iii) described above will be mainly explained, and unless otherwise specified, the explanations described in the first example may be applied.

As the organic material, a substituted or unsubstituted hydrocarbon compound having an acid anhydride group at two terminal parts is used. The compound may have two or more terminal parts, and may have an acid anhydride group at any two or more terminal parts.

The organic material is supplied between the first bonding part and the second bonding part, so that the acid anhydride groups of the organic material react with the silanol groups of the first bonding part and the second bonding part. Thereby, the reaction product derived from the organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

An exemplary reaction with use of an alkyl compound having an acid anhydride group at two terminal parts is shown in the following. 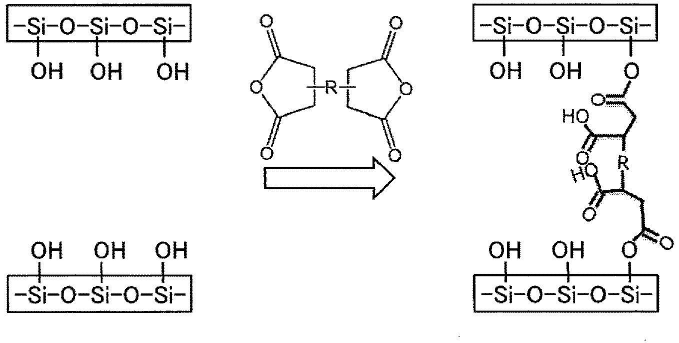 wherein R represents an alkyl group.

In the above, the first to third examples with use of a substituted or unsubstituted hydrocarbon compound having a hydrolyzable silyl group, an isocyanate group, or an acid anhydride group at two terminal parts as the organic material have been described; however, instead of/in addition to a hydrolyzable silyl group, an isocyanate group, or an acid anhydride group, a substituted or unsubstituted hydrocarbon compound having a hydroxyl group, an epoxy group and/or an amino group may be used. Any of the hydroxyl group, hydrolyzable silyl group, isocyanate group, epoxy group, amino group and acid anhydride group can function as a reactive group for silanol groups. These reactive groups on at least two terminal parts may be the same or different.

### · Example using organic material (iv)

In the example, differences from the first example using the organic material (iii) described above will be mainly explained, and unless otherwise specified, the explanations described in the first example may be applied.

As the organic material, silsesquioxane is used. Silsesquioxane means a silicon-containing polymer having a main chain composed of siloxane bonds (polysiloxane) with a T unit as fundamental structural unit. Silsesquioxane can be represented by a composition formula (R'SiO_{1.5})ₙ (R' may be any organic group and n is 6 or more), and may have a random structure, a ladder structure, a cage structure (complete cage structure and incomplete cage structure) or the like. Examples of the hydrocarbon group R' include an acyclic or cyclic aliphatic hydrocarbon group such as methyl, ethyl, propyl (n-propyl, i-propyl), butyl (n-butyl, i-butyl, t-butyl, sec-butyl), pentyl (n-pentyl, i-pentyl, neopentyl, cyclopentyl, etc.), hexyl (n-hexyl, i-hexyl, cyclohexyl, etc.), heptyl (n-heptyl, i-heptyl, etc.), octyl (n-octyl, i-octyl, t-octyl, etc.), nonyl (n-nonyl, i-nonyl, etc.), decyl (n-decyl, i-decyl, etc.), undecyl (n-undecyl, i-undecyl, etc.), and dodecyl (n-dodecyl, i-dodecyl, etc.), an acyclic and cyclic alkenyl group such as vinyl, propenyl, butenyl, pentenyl, hexenyl, cyclohexenyl, cyclohexenylethyl, norbornenylethyl, heptenyl, octenyl, nonenyl, decenyl, undecenyl, dodecenyl, and styrenyl, an aralkyl group such as benzyl, phenethyl, 2-methylbenzyl, 3-methylbenzyl, and 4-methylbenzyl, an aralkenyl group such as PhCH=CH- group, an aryl group such as phenyl group, tolyl group, or xylyl group, and a substituted aryl group such as 4-aminophenyl group, 4-hydroxyphenyl group, 4-methoxyphenyl group, and 4-vinylphenyl group.

The organic material is supplied between the first bonding part and the second bonding part, so that the siloxane bonding portion of the organic material react with the silanol groups of the first bonding part and the second bonding part (cleavage and addition of siloxane bond). Thereby, the reaction product derived from the organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

An exemplary reaction with use of T₈ silsesquioxane ((R'SiO_{1.5})₈) having a complete cage structure is shown in the following.

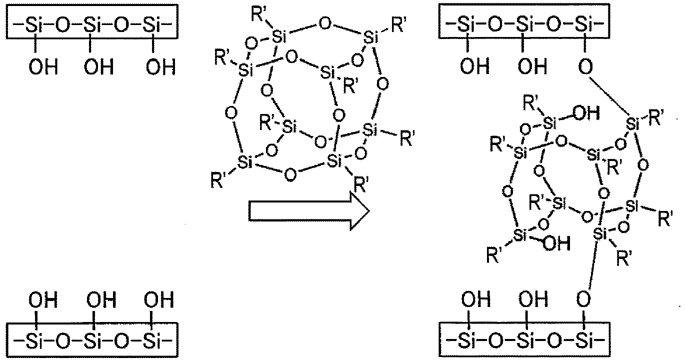

In order to obtain higher bonding strength, it is preferable that the organic material be a cage-type silsesquioxane having a definite molecular structure, though not limited thereto.

The example with use of silsesquioxane as the organic material has been described in the above; however, a derivative of silsesquioxane may be also used. The derivative of silsesquioxane may be a compound derived from silsesquioxane, and may have any substituent, modifying group, functional group, or the like.

### · Example using organic material (v)

In the example, differences from the first example using the organic material (iii) described above will be mainly explained, and unless otherwise specified, the explanations described in the first example may be applied.

A combination of two organic materials is used as the organic material. As a first organic material, a hydrolyzable hydrosilane or a substituted or unsubstituted hydrocarbon compound having a hydrolyzable silyl group at one terminal part and a hydrosilyl group at the other terminal part is used. As a second organic material, a substituted or unsubstituted hydrocarbon compound having a hydrolyzable silyl group at one terminal part and an alkenyl group at the other terminal part is used.

The first organic material can be a hydrolyzable hydrosilane or a substituted or unsubstituted hydrocarbon compound having a hydrolyzable silyl group at one terminal part and a hydrosilyl group at the other terminal part, and may be optionally a mixture thereof. The hydrolyzable hydrosilane may be one having H and one or more hydrolyzable groups on one Si. A substituted or unsubstituted hydrocarbon compound having a hydrolyzable silyl group at one terminal part and a hydrosilyl group at the other terminal part may have two or more terminal parts, and may have a hydrolyzable silyl group at any one or more terminal parts and a hydrosilyl group at any one or more terminal parts. A substituted or unsubstituted hydrocarbon compound having a hydrolyzable silyl group at one terminal part and a hydrosilyl group at the other terminal part may be the same as the substituted or unsubstituted hydrocarbon compound having hydrolyzable silyl groups at two terminal parts described in detail in the (iii), except for having a hydrosilyl group at the other terminal part.

The second organic material is a substituted or unsubstituted hydrocarbon compound having a hydrolyzable silyl group at one terminal part and an alkenyl group at the other terminal part. The compounds may have two or more terminal parts, and may have a hydrolyzable silyl group at any one or more terminal parts, and an alkenyl group at any one or more terminal parts. The substituted or unsubstituted hydrocarbon compound having a hydrolyzable silyl group at one terminal part and an alkenyl group at the other terminal part may be the same as the substituted or unsubstituted hydrocarbon compound having a hydrolyzable silyl group at two terminal parts described in detail in the (iii), except for having an alkenyl group at the other terminal part.

The first organic material is supplied to the first bonding part so that the hydrolyzable silyl group of the first organic material reacts with the silanol groups of the first bonding part (for example, in the case where the hydrolyzable group is an alkoxy group, a siloxane bonding is formed by dealcoholization), and the second organic material is supplied to the second bonding part so that the hydrolyzable silyl group of the second organic material reacts with the silanol group of the second bonding part (for example, in the case where the hydrolyzable group is an alkoxy group, a siloxane bonding is formed by dealcoholization). The first bonding part and the second bonding part are then disposed facing each other with an intermediate derived from the first organic material and an intermediate derived from the second organic material being located therebetween to cause a reaction of the intermediates (hydrosilylation). Thereby, the reaction product derived from the first organic material and the second organic material is chemically bound to the Si atoms of the first bonding part and the Si atoms of the second bonding part, so that the first bonding part and the second bonding part are bonded by the reaction product derived from the organic materials. Although an alcohol is produced as a by-product in such a reaction, the number of carbon atoms thereof can be small as described above, so that the by-product can be effectively removed before disposing the first bonding part and the second bonding part facing each other. Therefore, the formation of voids derived from by-products can be reduced.

An exemplary reaction with use of trimethoxyhydrosilane as the first organic material and vinyltrimethoxysilane as the second organic material is shown as follows.

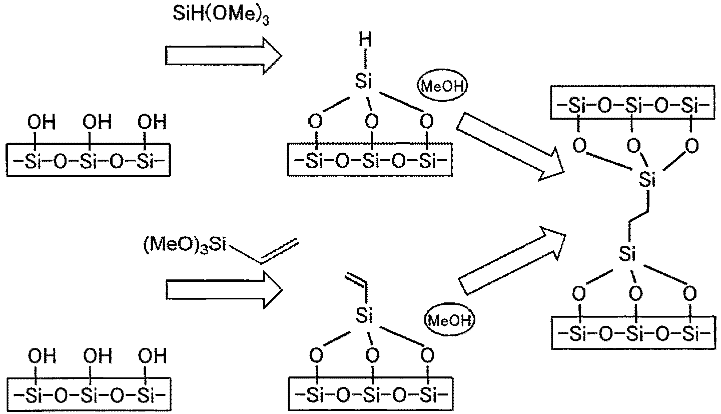

### · Example using organic material (vi)

In the example, differences from the first example using the organic material (iii) described above will be mainly explained, and unless otherwise specified, the explanations described in the first example may be applied.

As the organic material, a substituted or unsubstituted hydrocarbon compound having a hydrolyzable silyl group at one terminal part and an alkyl group at the other terminal part is used. The compound may have two or more terminal parts, and may have a hydrolyzable silyl group at any one or more terminal parts and an alkyl group at any one or more terminal parts. A substituted or unsubstituted hydrocarbon compound having a hydrolyzable silyl group at one terminal part and an alkyl group at the other terminal part may be the same as the substituted or unsubstituted hydrocarbon compound having hydrolyzable silyl groups at two terminal parts described in detail in the (iii), except for having an alkyl group at the other terminal part.

The organic material is supplied to the first bonding part so that the hydrolyzable silyl group of the organic material reacts with the silanol groups of the first bonding part (for example, in the case where the hydrolyzable group is an alkoxy group, a siloxane bonding is formed by dealcoholization), and the organic material is supplied to the second bonding part so that the hydrolyzable silyl group of the organic material reacts with the silanol group of the second bonding part (for example, in the case where the hydrolyzable group is an alkoxy group, a siloxane bonding is formed by dealcoholization). (The organic material to be supplied to the first bonding part and the organic material to be supplied to the second bonding part may be the same or different.) The first bonding part and the second bonding part are then disposed facing each other with an intermediate derived from the organic material being located therebetween to cause a reaction between the intermediates (radical reaction). The reaction between the intermediates (radical reaction) may be performed by UV irradiation, ion beams, weak plasma, or the like. Thereby, the reaction product derived from the organic material is chemically bound to the Si atoms of the first bonding part and the Si atoms of the second bonding part, so that the first bonding part and the second bonding part are bonded by the reaction product derived from the organic materials. Although an alcohol is produced as a by-product in such a reaction, the number of carbon atoms thereof can be small as described above. As a result, the by-product can be effectively removed before disposing the first bonding part and the second bonding part facing each other, so that the formation of voids derived from by-products can be reduced.

An exemplary reaction with use of ethyltrimethoxysilane is shown as follows.

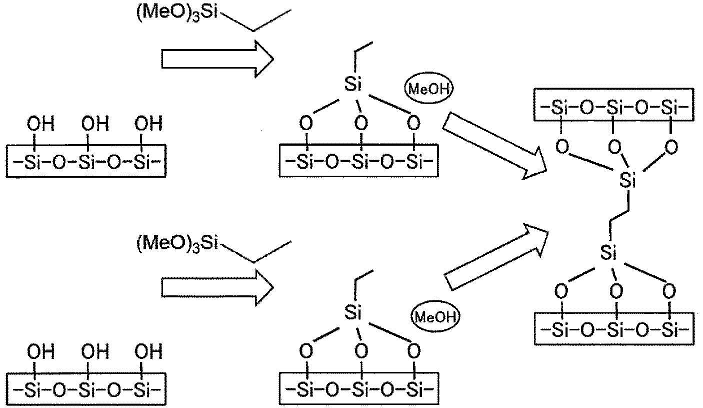

### · Example using organic material (vii)

In the example, differences from the first example using the organic material (iii) described above will be mainly explained, and unless otherwise specified, the explanations described in the first example may be applied.

As the organic material, a substituted or unsubstituted hydrocarbon compound having a hydrolyzable silyl group at one terminal part and a reactive functional group at the other terminal part is used. The compound may have two or more terminal parts, and may have a hydrolyzable silyl group at any one or more terminal parts and a reactive functional group at any one or more terminal parts. The substituted or unsubstituted hydrocarbon compound having a hydrolyzable silyl group at one terminal part and a reactive functional group at the other terminal part may be the same as the substituted or unsubstituted hydrocarbon compound having a hydrolyzable silyl group at two terminal parts described in detail in the (iii), except for having a reactive functional group at the other terminal part.

The reactive functional group may be typically at least one selected from the group consisting of an isocyanate group, an amino group, a hydroxyl group, a thiol group (also referred to as sulfanyl group), etc., though not limited thereto.

In the case where a substituted or unsubstituted hydrocarbon compound having a hydrolyzable silyl group at one terminal part and reactive functional group at the other terminal part is used as the organic material, an organic binding agent having two groups bindable to the reactive functional group of the hydrocarbon compound is also used. The organic binding agent may have two or more bindable groups, and more specifically may have the bindable groups at any two or more terminal parts. The number of carbons of the portion of the organic binding agent except for the bindable group is not limited, and may be, for example, 1 or more and 20 or less, particularly 5 or less. The portion except for the bindable group may be in a linear, branched or cyclic form. Typically, the organic binding agent may be a linear organic compound having a bindable group at both terminal parts, though not limited thereto.

The bindable group is selected depending on the reactive functional group. Examples of the combination of the reactive functional group and the group bindable thereto are shown in the following, though not limited thereto. One or more reactive functional groups may be used, and one or more bindable groups may be used as long as they can be bindable to the reactive functional groups.

**[Table 1]**

| | |
|---|---|
| Reactive functional group in organic material | Bindable group in organic binding agent |
| Isocyanate group | Amino group, hydroxyl group and thiol group |
| Amino group | Isocyanate group |
| Hydroxyl group | Isocyanate group |
| Thiol group | Isocyanate group |

The reactive functional group and the bindable group may be reactive with, or substantially non-reactive with, a hydrosilyl group and/or a silanol group. In the case where all of the reactive functional groups and bindable groups are reactive with hydrosilyl groups and/or silanol groups, it may be understood that two types of the organic materials (iii) described above are used, which can be left out of consideration in the case of using the organic material (vii), though.

Any appropriate method (scheme) may be applied for bonding the first bonding part and the second bonding part using the organic material and the organic binding agent. Three methods are shown in the following, though not limited thereto.

In a first method, the organic material and the organic binding agent are mixed (for example, immediately before use), and the resulting mixture is supplied between the first bonding part and the second bonding part, so that the hydrolyzable silyl groups of the organic material react with the silanol groups of the first bonding part and the second bonding part (for example, in the case where the hydrolyzable group is an alkoxy group, a siloxane bonding is formed by dealcoholization) . Thereby, the organic material is chemically bound to the Si atoms of the first bonding part and the Si atoms of the second bonding part. Also, the reactive functional groups of the organic material and the bindable groups of the organic binding agent are reacted to be bound. Thereby, the organic material chemically bound to the Si atoms of the first bonding part and the organic material chemically bound to the Si atoms of the second bonding part are bound through the organic binding agent. The reaction between the hydrolyzable silyl groups of the organic material and the silanol groups of the first bonding part and the second bonding part, and the reaction between the reactive functional groups of the organic material and the bindable groups of the organic binding agent may occur at any timing, and for example, any one of the reactions may proceed in advance, or the reactions may proceed at the same time. As a result, the first bonding part and the second bonding part are bonded by the reaction product derived from the organic material and the organic binding agent. Although, for example, an alcohol is produced as a by-product in the reaction in a preceding stage, the number of carbon atoms thereof can be small as described above, so that the by-product can be effectively removed to the outside through openings of the reaction product between the first bonding part and the second bonding part and the formation of voids derived from by-products can be reduced. In the reaction in the latter stage, for example, with a combination shown in Table 1, no by-product is produced.

In a second method, the organic material is supplied to the first bonding part so that the hydrolyzable silyl group of the organic material reacts with the silanol groups of the first bonding part (for example, in the case where the hydrolyzable group is an alkoxy group, a siloxane bonding is formed by dealcoholization), and the organic material is supplied to the second bonding part so that the hydrolyzable silyl group of the organic material reacts with the silanol group of the second bonding part (for example, in the case where the hydrolyzable group is an alkoxy group, a siloxane bonding is formed by dealcoholization). (The organic material to be supplied to the first bonding part and the organic material to be supplied to the second bonding part may be the same or different.) Thereby, the organic material is chemically bound to the Si atoms of the first bonding part and the Si atoms of the second bonding part. The first bonding part and the second bonding part are then disposed facing each other with an intermediate derived from the organic material being located therebetween together with the organic binding agent, so as to bind the reactive functional group of the organic material to the bindable group of the organic binding agent through a reaction. Thereby, the organic material chemically bound to the Si atoms of the first bonding part and the organic material chemically bound to the Si atoms of the second bonding part are bound through the organic binding agent. As a result, the first bonding part and the second bonding part are bonded by the reaction product derived from the organic material and the organic binding agent. Although, for example, an alcohol is produced as a by-product in the reaction in the preceding stage, the number of carbon atoms thereof can be small as described above, so that the by-product can be effectively removed before disposing the first bonding part and the second bonding part facing each other. Accordingly, the formation of voids derived from by-products can be reduced. In the reaction in the latter stage, for example, with a combination shown in Table 1, no by-product is produced.

In a third method, the organic material is supplied to the first bonding part so that the hydrolyzable silyl group of the organic material reacts with the silanol groups of the first bonding part (for example, in the case where the hydrolyzable group is an alkoxy group, a siloxane bonding is formed by dealcoholization), and the organic material is supplied to the second bonding part so that the hydrolyzable silyl group of the organic material reacts with the silanol group of the second bonding part (for example, in the case where the hydrolyzable group is an alkoxy group, a siloxane bonding is formed by dealcoholization). (The organic material to be supplied to the first bonding part and the organic material to be supplied to the second bonding part may be the same or different.) Thereby, the organic material is chemically bound to the Si atoms of the first bonding part and the Si atoms of the second bonding part (intermediate X). Then, the first bonding part is conveniently selected as one of the first bonding part and the second bonding part thus obtained, and the organic binding agent is supplied to the first bonding part, so that the reactive functional group of the organic material is bound to the bindable group of the organic binding agent through a reaction (intermediate Y). Then, the first bonding part thus obtained and the second bonding part obtained in the above are disposed facing each other. Between them, the intermediate Y derived from the organic material is disposed on the first bonding part side, and the intermediate X derived from the organic material and the organic binding agent is disposed on the second bonding part side, so that the reactive functional group of the intermediate X (the organic material) and the bindable group of the intermediate Y (the organic material + the organic binding agent) are bound through a reaction. Thereby, the organic material chemically bound to the Si atoms of the first bonding part and the organic material chemically bound to the Si atoms of the second bonding part are bound through the organic binding agent. As a result, the first bonding part and the second bonding part are bonded by the reaction product derived from the organic material and the organic binding agent. Although, for example, an alcohol is produced as a by-product in the reaction in the preceding stage, the number of carbon atoms thereof can be small as described above, so that the by-product can be effectively removed before disposing the first bonding part and the second bonding part facing each other. Accordingly, the formation of voids derived from by-products can be reduced. In this method, the unreacted organic binding agent that may remain on the second bonding part can be effectively removed before disposing the first bonding part and the second bonding part facing each other, accordingly, in a laminate to be finally obtained, unnecessary materials (not contributing to bonding) remaining between the first bonding part and the second bonding part can be reduced. In the reaction in the latter stage, for example, with a combination shown in Table 1, no by-product is produced.

An exemplary reaction with use of isocyanatomethyl trimethoxysilane as the organic material and ethylenediamine (1,2-diaminoethane) as the organic binding agent is shown in the following. In the following schematic diagram, the upper row shows the bonding part of one substrate only for convenience. The first method corresponds to the scheme indicated by the arrow pointing from the left side of the upper row to the lower row. The second method corresponds to the scheme indicated by the arrow pointing from the left side of the upper row to the center of the upper row and the arrow pointing from the center of the upper row to the lower row. The third method corresponds to the scheme indicated by the arrow pointing from the left side of the upper row to the center of the upper row, the arrow pointing from the center of the upper row to the right side of the upper row, and the arrow pointing from the right side of the upper row to the lower row (the same shall apply hereinafter).

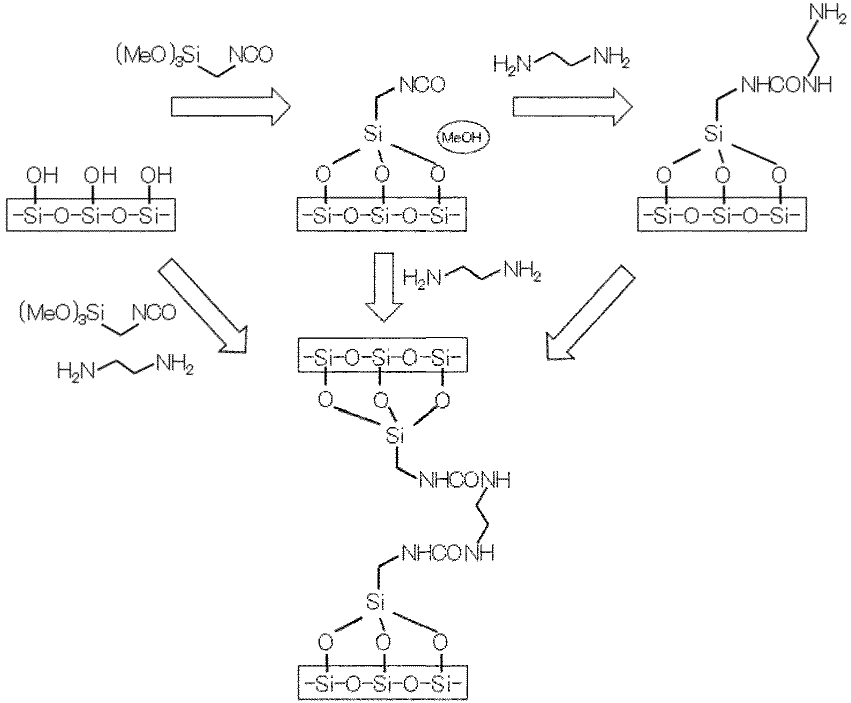

A reaction with use of isocyanatomethyl trimethoxysilane as the organic material and 1,2-ethanedithiol as the organic binding agent is shown below.

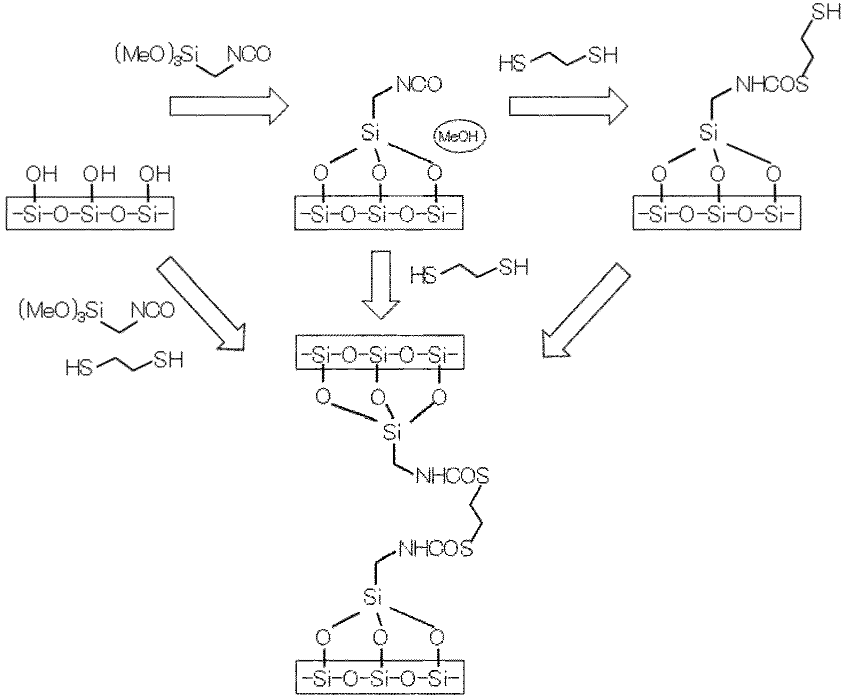

A reaction with use of isocyanatomethyl trimethoxysilane as the organic material and ethylene glycol (1,2-ethanediol) as the organic binding agent is shown below.

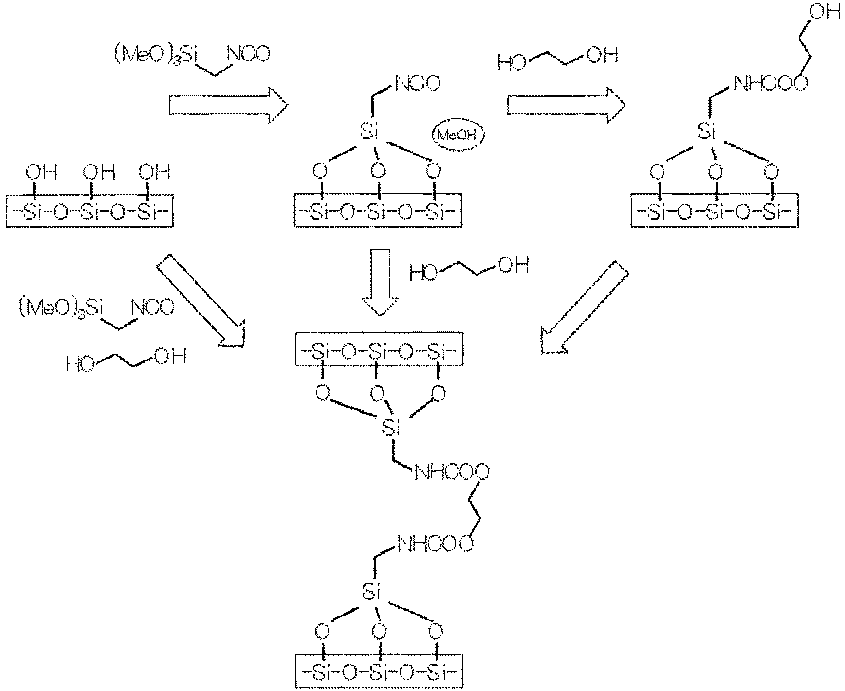

A reaction with use of aminomethyl trimethoxysilane as the organic material and ethylene diisocyanate (1,2-ethanediisocyanate) as the organic binding agent is shown below.

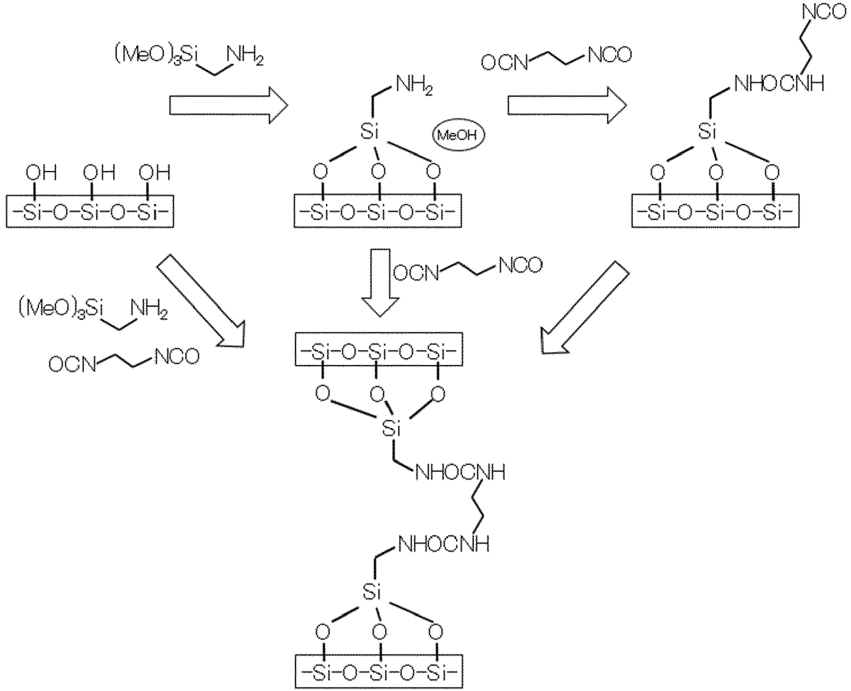

The exemplary aspects with use of organic materials (i) to (vii) have been described above, though the present embodiment is not limited thereto.

A laminate 40 of the present embodiment is produced as described above. In the laminate 40, a bonding layer 30 contains an organic substance. The organic substance may be presumed as residue of an organic material reactive with a hydrosilyl group and/or a silanol group.

The organic substance may be chemically bound to Si atoms of a first bonding part 13 and Si atoms of the second bonding part 23.

The bonding layer 30 may be made extremely thin. The thickness of the bonding layer 30 may be, for example, 10 nm or less, particularly 8 nm or less. The lower limit thereof may be, for example, 1 nm or more, though not limited.

According to the present embodiment, a laminate may be produced at a relatively low temperature, and the generation of voids can be effectively suppressed or prevented.

### (Embodiment 2)

The present embodiment relates to an aspect in which each of bonding parts of two silicon substrates is a silicon layer formed on a foundation part as a portion containing silicon oxide, and these bonding parts are directly bonded. In the present embodiment, differences from the embodiment 1 described above will be mainly explained, and unless otherwise specified, the explanations described in the embodiment 1 may be applied.

With reference to Figure 2, the laminate 40' of the present embodiment includes:
a first silicon substrate 10' having a first foundation part 15 and a first bonding part 17 formed thereon; and
a second silicon substrate 20' having a second foundation part 25 and a second bonding part 27 formed thereon.

A first silicon substrate 10' and a second silicon substrate 20' (hereinafter collectively also referred to simply as "silicon substrates") are not limited, as long as they have a first bonding part 17 and a second bonding part 27 (hereinafter collectively referred to simply as "bonding parts") to be bonded to each other on the first foundation part 15 and the second foundation part 25 (hereinafter collectively also referred to as simply "foundation parts"), respectively.

In an aspect shown in Figure 2, a first bonding part 17 may be a film on a first foundation part 15 formed on the entire surface of one side of a body part 11 of a first silicon substrate 10', and a second bonding part 27 may be a film on a second foundation part 25 formed on the entire surface of one side of a body part 21 of a second silicon substrate 20', though the present embodiment is not limited thereto. For example, the bonding part may be a portion adjacent to a metal portion provided on the foundation part on the surface of a side of the silicon substrate, more specifically, a portion between the two metal portions, provided on the foundation part. In that case, the first silicon substrate and the second silicon substrate may be hybrid bonded.

The laminate 40' of the present embodiment has no bonding layer containing an organic substance between the first bonding part 17 and the second bonding part 27, and the first bonding part 17 and the second bonding part 27 are directly bonded to each other, being different from the laminate in embodiment 1.

Such a laminate may be produced by the following production method. The method for producing the laminate of the present embodiment includes:
(c) providing a first silicon substrate 10' having a first foundation part 15 and a first bonding part 17 formed thereon, and a second silicon substrate 20' having a second foundation part 25 and a second bonding part 27 formed thereon; and
(d) bonding the first bonding part 17 and the second bonding part 27 directly.

Each step will be described in detail in the following.

### · Step (c)

In the present embodiment, the foundation part may be a portion containing silicon oxide (hereinafter also referred to as "silicon oxide portion"). The silicon oxide portion may be the same as the silicon oxide portion described above as the bonding part in embodiment 1.

In the present embodiment, the bonding part may be a silicon layer. The silicon layer may be composed of silicon or may contain any other suitable substance in addition to silicon. Examples of the other substances include impurities that may be unavoidably mixed.

In the present embodiment, the thickness of the bonding part as a silicon layer may be, for example, 100 nm or less, particularly 10 nm or less, and the lower limit may be, for example, 1 nm or more, though not limited.

The bonding part as a silicon layer may be formed, for example, by depositing silicon on a foundation layer as a silicon oxide portion. The deposition of silicon may be performed by any one of sputtering, chemical vapor deposition (CVD), plasma enhanced chemical vapor deposition (PECVD), and vapor deposition, or by any combination of two or more thereof. The bonding part as a silicon layer, however, may be formed by any appropriate method without limitation thereto.

A small amount of silanol groups (-Si-OH) are always present on the surface of the bonding part as a silicon layer.

In the present embodiment, after the step (c) and before the step (d), both the first bonding part and the second bonding part are not subjected to surface treatment to generate hydrosilyl groups and/or silanol groups.

Otherwise, the step (c) may be the same as the step (a) in the production method in the embodiment 1.

### · Step (d)

Next, the first bonding part and the second bonding part are directly bonded.

The direct bonding may be performed, for example, by superimposing a first silicon substrate and a second silicon substrate with the first bonding part and the second bonding part facing each other, and pressing the first bonding part and the second bonding part in close contact with each other while heating. The heating temperature may be, for example, 800°C or more, though not limited, and the upper limit may be, for example, 1,000°C or less, though not limited.

Thereby, the first bonding part and the second bonding part are directly bonded (adhered/bound to each other). Although the present embodiment is not bound by any theory, it is presumed that the direct bonding may be brought about by the formation of siloxane bonds between silanol groups present on the surface of the first bonding part and silanol groups present on the surface of the second bonding part (hydrophilic bonding). More specifically, it is presumed that while the temperature increases by heating, bonds across the interface between the first bonding part and the second bonding part are formed by hydrogen bond of water molecules in the range up to about 110°C, siloxane bonds begin to be formed with water molecules missing at the interface in the range from about 110°C to about 150°C, stable siloxane bonds are formed in the range from about 150°C to about 800°C, and a uniform bonding is formed by viscous flow of the oxide layer at the interface at about 800°C or more.

The laminate 40' of the present embodiment is produced as described above.

Direct bonding can be identified, for example, as follows. FIB-SEM (focused ion beam combined processing scanning electron microscope) and/or TEM-EDS (transmission electron microscopic energy dispersive x-ray analysis) are used to analyze the bonding interface. In the case of organic molecular bonding, elements (C, F, etc.) derived from organic molecules are detected, while in the case of direct bonding, elements (C, F, etc.) derived from organic molecules are not detected. Further, while etching the surface exposed by FIB processing or the like with argon ions or the like, the bonding interface is analyzed by SIMS (secondary ion mass spectrometry) and/or XPS (X-ray photoelectron spectroscopy). In the case of organic molecular bonding, ions and elements derived from organic molecules are detected, while in the case of direct bonding, Si and O only are detected. Accordingly, in the case where the elements and ions derived from organic molecules are not detected, and Si and O only are detected as the results of these analyses, a direct bonding can be identified.

### (Embodiment 3)

The present embodiment relates to an aspect in which each of bonding parts of two silicon substrates is a silicon layer formed on a foundation part as a portion containing silicon oxide, and these bonding parts are bonded using hydrosilyl groups present on the surface thereof. In the present embodiment, differences from the embodiment 2 described above will be mainly explained, and unless otherwise specified, the explanations described in the embodiment 2 may be applied.

The laminate of the present embodiment may have the same structure as that of the laminate 40' described above with reference to Figure 2.

The laminate 40' of the present embodiment is different from the laminate of the embodiment 2 in terms of bonding of the first bonding part 17 and the second bonding part 27 using hydrosilyl groups present on the surface of the bonding part instead of direct bonding.

Such a laminate may be produced by modifying the production method described above in the embodiment 2.

### · Step (c)

In the present embodiment, after step (c) and before step (d), at least one, preferably both, of the first bonding part and the second bonding part as silicon layers are subjected to a surface treatment to produce hydrosilyl groups. Thereby, hydrosilyl groups (-Si-H) are present on the surface of the bonding part at a higher density. Incidentally, a small amount of silanol groups (-Si-OH) are always present on the surface of the bonding part as a silicon layer even after the surface treatment for producing hydrosilyl groups.

The surface treatment to produce hydrosilyl groups may be the same as described above in the embodiment 1.

### · Step (d)

Next, the first bonding part and the second bonding part are bonded using the hydrosilyl groups present on the surfaces.

The bonding with the hydrosilyl groups may be performed, for example, by superimposing a first silicon substrate and a second silicon substrate with the first bonding part and the second bonding part facing each other, and pressing the first bonding part and the second bonding part in close contact with each other while heating. The heating temperature may be, for example, 100°C or more, though not limited, and the upper limit may be, for example, 800°C or less, though not limited.

Thereby, the first bonding part and the second bonding part are bonded (adhered/bound to each other) using the hydrosilyl groups present on the surfaces. Although the present embodiment is not bound by any theory, it is presumed that the bonding with the hydrosilyl group is brought about by some sort of reaction and/or electric effect (for example, electric affinity) between the hydrosilyl groups present on the surface of the first bonding part and the hydrosilyl groups present on the surface of the second bonding part in the case where the hydrosilyl groups are present on both of the surfaces of the first bonding part and the second bonding part, or between the hydrosilyl groups present on the surface of one of the first bonding part and the second bonding part and the silanol groups present on the surface of another one in the case where the hydrosilyl groups are present on the surface of any one of the first bonding part and the second bonding part. Further, it is presumed that some sort of reaction and/or electric effect (for example, electric affinity) may be produced also between the silanol groups present on the surface of the first bonding part and the silanol groups present on the surface of the second bonding part, and thereby the bonding can be reinforced.

The laminate of the present embodiment is produced as described above.

The bonding with use of hydrosilyl groups may be identified, for example, as follows. As a result of analysis in the same manner as described above in the embodiment 2, in the case where no elements and ions derived from organic molecules were detected and Si, O and H only were detected, the bonding with use of hydrosilyl groups can be identified.

Three embodiments of the present disclosure have been described above, though the present disclosure is not limited thereto, and any appropriate modification may be made. For example, in the embodiments 1 to 3, the two silicon substrates are bonded on one side each over the entire surface in an aspect shown in drawing, though the present disclosure is not limited to the aspect. For example, two silicon substrates may be bonded in a partial areas. Alternatively, three or more silicon substrates may be bonded as follows. Different silicon substrates may be bonded to both sides of one silicon substrate over the entire surface/partial region, or two or more silicon substrates may be bonded to one surface of one silicon substrate in separate regions. The aspects described above may be combined.

### Industrial Applicability

The method for producing a laminate and the laminate of the present disclosure can be suitably used for lamination of silicon substrates and for three-dimensional integration technology of silicon semiconductors.

The present application claims priority based on Japanese Patent Application No. 2021-108617 filed in Japan on June 30, 2021 and Japanese Patent Application No. 2021-168166 filed in Japan on October 13, 2021, and the entire contents thereof are incorporated herein by reference.

### Reference Signs List

- 11:: first main body part
- 13:: first bonding part (silicon oxide portion)
- 15:: first foundation part (silicon oxide portion)
- 17:: first bonding part (silicon layer)
- 10, 10':: first silicon substrate
- 21:: second main body part
- 23:: second bonding part (silicon oxide portion)
- 25:: second foundation part (silicon oxide portion)
- 27:: second bonding part (silicon layer)
- 20, 20':: second silicon substrate
- 30:: bonding layer
- 40, 40':: laminate

## Claims

1. A method for producing a laminate including two silicon substrates, comprising:
(a) providing a first silicon substrate having a first bonding part and a second silicon substrate having a second bonding part, wherein the first bonding part and the second bonding part are portions containing a silicon oxide; and
(b) using an organic material reactive with a hydrosilyl group and/or a silanol group to thereby bond the first bonding part and the second bonding part by a reaction product derived from the organic material.

2. The method for producing a laminate according to claim 1,
wherein the organic material has at least one selected from the group consisting of an alkenyl group, a hydroxyl group, a hydrolyzable silyl group, an isocyanate group, an epoxy group, an amino group, an acid anhydride group and a siloxane bond.

3. The method for producing a laminate according to claim 1 or 2, further comprising:
subjecting at least one of the first bonding part and the second bonding part to a surface treatment to produce a hydrosilyl group and/or a silanol group, after the (a) and before the (b).

4. The method for producing a laminate according to claim 3, wherein the surface treatment includes at least one selected from the group consisting of hydrogen atom treatment, heat treatment in a hydrogen-containing atmosphere, sputtering treatment, chemical vapor deposition treatment, and terminal treatment with a chemical solution.

5. The method for producing a laminate according to claim 3 or 4, wherein the organic material comprises at least one selected from the group consisting of:
(i) a substituted or unsubstituted hydrocarbon compound having alkenyl groups at two terminal parts; and
(ii) a substituted or unsubstituted hydrocarbon compound having an alkenyl group at one terminal part and any one selected from the group consisting of a hydroxyl group, a hydrolyzable silyl group, an isocyanate group, an epoxy group, an amino group and an acid anhydride group at the other terminal part.

6. The method for producing a laminate according to any one of claims 1 to 5, wherein the organic material comprises at least one selected from the group consisting of:
(iii) a substituted or unsubstituted hydrocarbon compound having any one independently selected from the group consisting of a hydroxyl group, a hydrolyzable silyl group, an isocyanate group, an epoxy group, an amino group and an acid anhydride group at two terminal parts;
(iv) silsesquioxane and a derivative thereof;
(v) a combination of a hydrolyzable hydrosilane or a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and
(vi) a substituted or unsubstituted hydrocarbon compound having a hydrolyzable silyl group at one terminal part and an alkyl group at the other terminal part.

7. The method for producing a laminate according to any one of claims 1 to 6,
wherein the organic material includes:
(vii) a substituted or unsubstituted hydrocarbon compound having a hydrolyzable silyl group at one terminal part and a reactive functional group at the other terminal part; and
the (b) is using the organic material and an organic binding agent having two groups bindable to the reactive functional group of the hydrocarbon compound (vii) of the organic material to thereby bond the first bonding part and the second bonding part by a reaction product derived from the organic material and the organic binding agent.

8. The method for producing a laminate according to any one of claims 1 to 7, wherein the (b) includes maintaining the first silicon substrate and the second silicon substrate at a temperature of 200°C or less.

9. The method for producing a laminate according to any one of claims 1 to 8, wherein the (b) includes maintaining the first silicon substrate and the second silicon substrate at a pressure of 10⁻⁸ Pa or more and 10⁵ Pa or less.

10. A method for producing a laminate including two silicon substrates, comprising:
(c) providing a first silicon substrate having a first foundation part and a first bonding part formed thereon and a second silicon substrate having a second foundation part and a second bonding part formed thereon, wherein the first foundation part and the second foundation part are portions containing silicon oxide, and the first bonding part and the second bonding part are silicon layers; and
(d) bonding the first bonding part and the second bonding part directly, or using a hydrosilyl group present on a surface of at least one of the first bonding part and the second bonding part.

11. A laminate comprising two silicon substrates, comprising:
a first silicon substrate having a first bonding part;
a second silicon substrate having a second bonding part; and
a bonding layer bonding the first bonding part to the second bonding part,
wherein the first bonding part and the second bonding part are portions containing silicon oxide, and the bonding layer contains an organic substance chemically bound to Si atoms of the first bonding part and Si atoms of the second bonding part.

12. A laminate comprising two silicon substrates, comprising:
a first silicon substrate having a first bonding part;
a second silicon substrate having a second bonding part;
a bonding layer bonding the first bonding part to the second bonding part,
wherein the first bonding part and the second bonding part are portions containing silicon oxide, and the bonding layer contains an organic substance and has a thickness of 10 nm or less.

13. The laminate according to claim 11 or 12, wherein the organic substance contains a residue of an organic material reactive with a hydrosilyl group and/or a silanol group.

14. A laminate comprising two silicon substrates, comprising:
a first silicon substrate having a first foundation part and a first bonding part formed thereon;
a second silicon substrate having a second foundation part and a second bonding part formed thereon;
wherein the first foundation part and the second foundation part are portions containing silicon oxide, the first bonding part and the second bonding part are silicon layers, and the first bonding part and the second bonding part are directly bonded, or bonded using a hydrosilyl group present on a surface of at least one of the first bonding part and the second bonding part.
